(19) Europäisches Patentamt
European Patent Office
Office européen des brevets

(11) **EP 0 731 495 B1**

(12) **EUROPÄISCHE PATENTSCHRIFT**

(45) Veröffentlichungstag und Bekanntmachung des Hinweises auf die Patenterteilung:
**27.09.2000   Patentblatt 2000/39**

(51) Int Cl.⁷: **H01L 21/302**, B08B 3/04

(21) Anmeldenummer: **95108823.6**

(22) Anmeldetag: **08.06.1995**

(54) **Verfahren und Vorrichtung zum Reinigen von Siliziumscheiben**

Process and device for cleaning silicon wafers

Méthode et dispositif de nettoyage de tranches de silicium

(84) Benannte Vertragsstaaten:
**DE FR GB IT NL**

(30) Priorität: **10.03.1995  DE 19508577**

(43) Veröffentlichungstag der Anmeldung:
**11.09.1996   Patentblatt 1996/37**

(73) Patentinhaber: **ASTEC Halbleitertechnologie GmbH**
**D-95490 Mistelgau (DE)**

(72) Erfinder:
• **Kaltenbach, Konrad**
**D-78120 Furtwangen (DE)**
• **Stadler, Maximilian Dr.**
**D-84533 Heiming (DE)**

(74) Vertreter: **Patentanwälte**
**Westphal, Mussgnug & Partner**
**Waldstrasse 33**
**78048 Villingen-Schwenningen (DE)**

(56) Entgegenhaltungen:
| | |
|---|---|
| **EP-A- 0 497 247** | **WO-A-95/04372** |
| **DE-A- 3 818 714** | **DE-A- 4 340 589** |
| **DE-C- 4 209 865** | **JP-A- 6 053 201** |

• **PATENT ABSTRACTS OF JAPAN, unexamined applications, E Sektion, Band 14, Nr. 425, 13 September 1990 THE PATENT OFFICE JAPANESE GOVERNMENT Seite 77 E 977; & JP-A-02 164 035 (NEC CORP)**
• **PATENT ABSTRACTS OF JAPAN, unexamined applications, E Sektion, Band 16, Nr. 435, 10. September 1992 THE PATENT OFFICE JAPANESE GOVERNMENT Seite 20 E 1263; & JP-A-04 151 835 (SHIMADA PHYS & CHEM IND CO LTD)**

## Beschreibung

Die Erfindung betrifft ein Verfahren zum Reinigen von Siliziumscheiben sowie eine Vorrichtung zur Durchführung eines solchen Verfahrens.

Aus dem Artikel "Native Oxide Growth and Organic Impurity Removal on Si Surface with Ozone-Injected Ultrapure Water" von T. Ohmi u. a. in J. Electrochem. Soc., Band 140, Nr. 3, März 1993, ist eine Verbesserung (nachfolgend Ohmi-Verfahren genannt) des sogenannten RCA-Verfahrens für Siliziumscheiben bekannt. Da bei der Herstellung von Siliziumscheiben (wafers) für die Halbleitertechnologie und deren Weiterverarbeitung zu elektronischen Bauelementen Verunreinigungen nicht zu vermeiden sind, müssen die Siliziumscheiben an bestimmten Stellen des Herstellungsverfahrens gründlich gereinigt werden. Beim Ohmi-Verfahren werden die Siliziumscheiben nacheinander in ortsfeste Bäder eingebracht, die jeweils aus Reinigungsflüssigkeiten unterschiedlicher chemischer Zusammensetzung gebildet sind. Zwischen dem Verweilen in den einzelnen Bädern und nach dem letzten Bad werden die Siliziumscheiben dem jeweiligen Bad entnommen und mit ultrareinem Wasser, z.B. DI-Wasser, gespült oder auch in ein ortsfestes Spülbad aus ultrareinem Wasser eingelegt. Als Reinigungsflüssigkeit für die einzelnen Bäder werden von Ohmi die folgenden Mischungen vorgeschlagen:

1. $H_2O + O_3$
2. $NH_4OH + H_2O_2$
3. $HF + H_2O_2$

Für eine bestimmte Zeit nach der Herstellung der genannten Mischungen sind diese Mischungen als Reinigungsflüssigkeiten zur Entfernung insbesondere metallischer und organischer Kontaminationen (Partikel auf der Oberfläche der Siliziumscheiben, aber auch kovalente Bindungen Si-$CX_n$) geeignet. Bei Herstellung der genannten Mischungen entstehen insbesondere OH-Radikale, deren Konzentration in der Reinigungsflüssigkeit hauptsächlich für die Reinigungswirkung verantwortlich ist.

Bei der bekannten Ohmi-Reinigung ist eine Rekontamination der fertig gereinigten Siliziumscheiben durch Verunreinigungen der eingesetzten Chemikalien und beim Umsetzen zwischen den einzelnen Reinigungs- und Spülbädern kaum zu vermeiden. Da die endgültig erzeugte Oberfläche hydrophob ist, wenn zuletzt mit der HF enthaltenden Mischung gereinigt wird, ergibt sich auch eine verhältnismäßig starke Partikelanziehung aus der Umgebungsluft an die Oberflächen der Siliziumscheiben. Auch hat man bei dem bekannten Verfahren keine Kontrolle über den autokatalytischen Zerfall von $H_2O_2$ und die chemische Reaktivität der entstehenden OH-Radikale, die an der Si-Oberfläche angesetzt werden.

Darüber hinaus ist aus dem Artikel "An HF-$O_3$ Aqueous Solution for Silicon Wafer Cleaning" von Fukazawa et al, enthalten in dem Tagungsband "Proceedings of the Second International Symposium on Ultra-Clean Processing of Silicon Surfaces (UCPSS '94), Seiten 267 bis 270, veröffentlicht von Ultgeverej Acco, Leuven, Belgien, ISBN 90-334-3262-5, ein Verfahren zum Reinigen von Siliziumscheiben beschrieben, bei welchem diese in ein Bad eingebracht werden, das als Bestandteile Ozon ($O_3$), deionisiertes Wasser und HF aufweist. In der genannten Veröffentlichung wird vorgeschlagen, 2ppm bis 10ppm (parts per million bzw. Milligramm pro Liter) $O_3$ in deionisiertes Wasser einzuleiten und zu lösen. Es werden also $O_3$-Lösungen in $H_2O$ von 2ppm und 10ppm hergestellt. Diese werden mit Fluor-Wasserstoff (HF) vermischt und ergeben nach dem Mischen eine 0,5 %ige HF-Lösung (Anm.: Diese Prozentangabe steht für Gewichtsprozent, also %gew) bezogen auf g/l für Flüssigkeiten oder mg/l für Gase). Nach dem Herstellen dieser 0,5 %igen HF-Lösung werden die zu reinigenden Siliziumscheiben in diese Reinigungsflüssigkeit bei Zimmertemperatur für 3 Minuten eingebracht.

Der wesentliche Vorteil dieses Verfahrens besteht darin, daß die zu reinigenden Siliziumscheiben in einem Reinigungsbecken verbleiben können und nicht in andere Reinigungsbecken umgesetzt werden müssen, wodurch die Siliziumscheiben wieder verunreinigt werden könnten. Problematisch bei diesem bekannten Verfahren ist jedoch die geringe Löslichkeit von $O_3$ in Wasser. Darüber hinaus hat sich herausgestellt, daß die Konzentration von $O_3$ während der dreiminütigen Behandlungszeit, bedingt durch die Reaktion mit der Oberfläche der Siliziumscheibe, sinkt. Dieses Sinken der Konzentration $O_3$ wird darüber hinaus noch durch den Zerfall von $O_3$ und Rekombination zu $O_2$ beschleunigt. Damit nimmt aber die Reinigungseffektivität ab.

Des Weiteren ist aus DE-A 43 40 589 bereits ein Verfahren zum Reinigen von Siliziumscheiben bekannt. Bei diesem Verfahren werden die Siliziumscheiben in ein Bad mit einer Reinigungsflüssigkeit aus einer mit einem $O_3$-Gasstrom (Ozon) durchströmten wässrigen HF-Lösung gebracht.

Aus DE-C-42 09 865 ist schließlich ein Reinigungsverfahren bekannt, bei dem dem wässrigen Reinigungsmittel Kohlendioxyd und/oder Oxalsäure zugegeben wird.

Der Erfindung liegt die Aufgabe zugrunde, das zuletzt genannte Reinigungsverfahren weiter zu verbessern und eine Vorrichtung zur Durchführung desselben bereitzustellen.

Diese Aufgabe wird erfindungsgemäß beim Verfahren durch die Merkmale des Anspruchs 1 und bei der Vorrichtung durch die Merkmale des Anspruchs 12 gelöst.

Das erfindungsgemäße Verfahren zum Reinigen von Siliziumscheiben beruht darauf, die Siliziumscheiben in ein Bad einzubringen, das als Reinigungsflüssigkeit aus einer mit einem $O_3$-Gasstrom durchströmten wässrigen HF-Lösung besteht, wobei die HF-Konzentration 0,1 bis 50 %ig ist und $10^{-6}$ bis 10 % eines Tensides zugegeben werden.

Im Gegensatz zum Stand der Technik wird also $O_3$ nicht in deionisiertes, also voll entsalztes Wasser eingeleitet und gelöst, sondern direkt in eine wässrige HF-Lösung eingeleitet. Hierbei wird der Vorteil ausgenutzt, dass die Löslichkeit von Ozon in HF größer ist als in Wasser. Das Einbringen von Ozon erfolgt in eine zirkulierende HF-Lösung, wobei $O_3$ vorteilhafterweise in die Saugleitung einer Kreiselpumpe eingebracht wird, die für eine Feinverteilung der Gasbläschen und somit für eine optimale Ozonlöslichkeit sorgt. Durch die erfindungsgemäße Zugabe eines oder mehrerer Tenside wird dieser Effekt enorm erhöht.

Durch die erfindungsgemäße Zugabe eines Tensides oder Tensiden zur Reinigungsflüssigkeit und dessen Bewegung werden zusätzlich zu den Metallen Partikel von der Oberfläche der zu reinigenden Siliziumscheibe abgelöst und ausgetragen.

Es ist vorgesehen, dass während der Behandlungszeit das Verhältnis $O_3$:HF vergrößert wird. Gegen Ende der Behandlungszeit ist es zweckmäßig, deionisiertes Wasser zuzuleiten und den Überlauf zu verwerfen. Dadurch wird der Spülprozess eingeleitet, der bei einer HF-Konzentration on 0,0 abgeschlossen ist. Hierdurch kann die chemische Behandlung der zu reinigenden Siliziumscheibe und der Spülprozess in einem Becken durchgeführt werden, ohne dass die frisch gereinigte Oberfläche der Siliziumscheibe durch einen Handlingsakt, also Umsetzen in ein Spülbad, zwischenzeitlich der Atmosphäre ausgesetzt ist. Leitet man nun erneut bei dem Stand HF = 0,0 %ig Ozon durch jetzt reines deionisiertes Wasser, so werden die Siliziumscheiben hydrophiliert und können letztlich aus einem Bad mit HF-Behandlung, das die Siliziumscheiben hydrophob macht, hydrophil entnommen werden. Dieses Einleiten von $O_3$ führt außerdem zu einem Abbau von Tensidresten bis zur völligen Freiheit von Organikas.

Die gegenüber einer Lösung in $H_2O$ erhöhte Löslichkeit von Ozon in wässriger Flusssäure führt zu einer Erhöhung der OH-Radikalkonzentration, die in dem Fachmann geläufiger Weise über die Zeit konstant eingestellt werden kann. Auch gegenüber anderen bekannten Reinigungsmischungen dieser Art, z. B. $H_2SO_4 + H_2O_2$ sowie $H_2SO_4 + O_3$, $NH_4OH$ (bzw. TMAH) $+ H_2O_2$ sowie $NH_4OH + O_3$, $HCl + H_2O_2$ sowie $HCl + O_3$ wird beim erfindungsgemäße Verfahren eine erhöhte Partikelreduzierung beobachtet. Der Hauptvorteil des erfindungsgemäßen Verfahrens besteht in der sogenannten "Eintopfreaktion", die ohne Umsetzung von Bad zu Bad und dadurch Möglichkeit zur Rekontamination zu einer optimalen und im Vergleich zum Stand der Technik schnelleren Entfernung von metallischen und organischen Kontaminationen auf der Oberfläche und unmittelbar unter der Oberfläche (subsurface contamination) der Siliziumscheiben führt. Auch die erforderlichen Versorgungs- und Entsorgungsvorgänge sind weniger aufwendig. Insbesondere ergibt sich auch eine erhebliche Platzersparnis durch die Reinigung in nur einem Bad.

Die Unteransprüche 2 bis 11 betreffen vorteilhafte Ausgestaltungen des erfindungsgemäßen Verfahrens. So bezieht sich der Anspruch 3 auf die Zugabe einer vorteilhaften Menge eines Tensides zur Reinigungsflüssigkeit, was zu einer optimalen Gasverteilung im Bad führt und somit die Löslichkeit, d. h. die aktive Ozonmenge pro Volumeneinheit erhöht und die Reeaktivität des Ozons verbessert.

Eine weitere Verbesserung der Wirkung des erfindungsgemäßen Reinigungsverfahrens lässt sich durch eine Erwärmung gemäß den Ansprüchen 3 und 4 erzielen.

Auch durch das Umströmen der Siliziumscheiben durch die Reinigungsflüssigkeit gemäß Anspruch 5 lässt sich das Verfahren verbessern, wobei die Ansprüche 6 und 7 bevorzugte Bereiche für die Strömungsgeschwindigkeit angeben.

Erfindungsgemäß wird das Konzentrationsverhältnis von $O_3$ : HF während der Reinigung vergrößert. Durch die Kontrolle der Ozonerzeugung im Ozongenerator (Einstellgrößen : Spannung, Vordruck, $O_2$-Strom) kann nämlich die Ozonkonzentration im $O_3/O_2$-Strom definiert eingestellt werden, was schließlich im Reinigungsbad durch den Abbau von $O_3$ zu definierten OH-Radikalkonzentrationen führt, wenn die Anteile konkurrierender Radikalreaktionen (z. B. Rekombination) experimentell ermittelt worden und als Erfahrungswert in die Bilanz eingebracht sind. Die Radikalkonzentration, die letztlich aktiv am Reinigungsgeschehen teilnimmt, ist somit über die Einstellgrößen (am Ozongenerator) und deren Messung und Kontrolle definiert zu verändern (vergrößern und verkleinern), aber auch konstant zu halten. Theoretisch kann folgende Beziehung aufgestellt werden:

$$[\dot{O}H] = 2\,\beta\,[O_3]\,, \ \beta \le 1$$

mit

$$ \beta = 1 - \sum_{i=1}^{n} \alpha_i \qquad , \ \alpha_i \ \le \ 1 $$

wobei $\alpha_i$ die Anteilsfaktoren der Radikalreaktionen sind, die keine chemische Beziehung mit der Si-Oberfläche einge-hen. $\Sigma \ \alpha_i$ muss experimentell ermittelt werden und ist systemspezifisch, dann aber konstant.

Ein Ansteigen des Konzentrationsverhältnisses von $O_3$ : HF gegen Ende des Reinigungsverfahrens ist deswegen vorteilhaft, da hierdurch eine Reaktion von HF mit $SiO_2$ im Wesentlichen beendet wird, so dass die gereinigten Siliziumscheiben mit im Wesentlichen hydrophilen Oberflächen entnommen werden können. Auch hierdurch wird eine Rekontamination mit Partikeln noch weiter verringert.

Es ist auch möglich, gemäß Anspruch 8 das Konzentrationsverhältnis $O_3$ : HF stufenweise zu vergrößern, wobei vorzugsweise zwischendurch und am Ende des Verfahrens ein Spülen mit ultrareinem Wasser erfolgt.

Während sich in Anspruch 9 auf die Durchführung des gesamten Verfahrens in einer sogenannten "Eintopfreaktion" bezieht, betreffen die Ansprüche 10 und 11 besondere Ausführungsformen des Verfahrens, wobei insbesondere durch Anspruch 11 eine weitere Materialersparnis erzielt werden kann.

Nach den Ansprüchen 12 und 13 wird das erfindungsgemäße Reinigungsverfahren in einem einzigen Behälter durchgeführt.

Eine Möglichkeit zum Rezirkulieren (und ggf. Zwischenreinigen) sowie Erwärmen der Reinigungsflüssigkeit ist durch die Maßnahmen gemäß den Ansprüchen 14 und 15 gegeben.

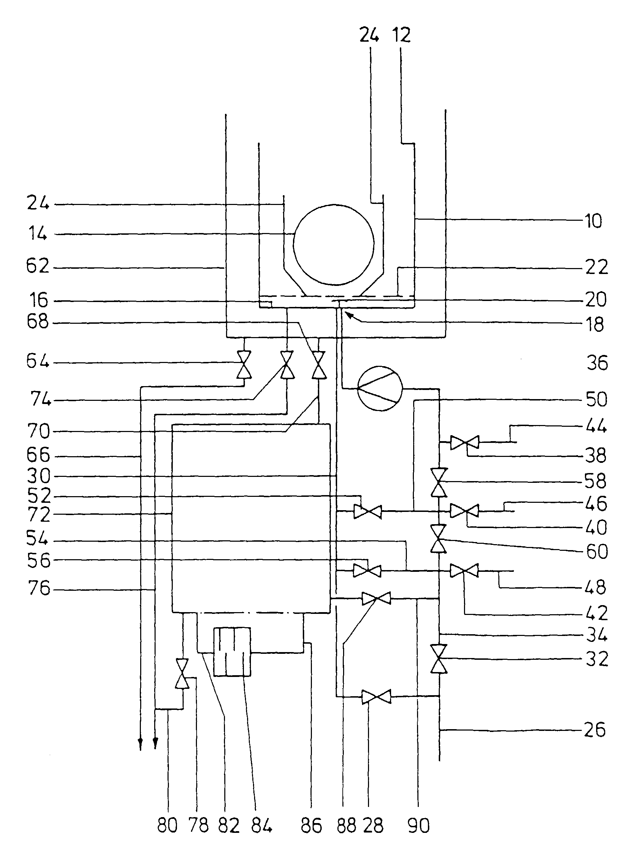

Anhand der beigefügten Figur wird nachfolgend ein Ausführungsbeispiel der erfindungsgemäßen Vorrichtung beschrieben, wobei die Figur ein schematisches Schaltbild der Vorrichtung wiedergibt.

In einem oben offenen Behälter 10, der z. B. eine Höhe von 35 cm, eine Breite von 30 cm und eine Tiefe von 30 cm besitzt und an allen Kanten und Ecken abgerundet sowie mit einem allseitigen, in nicht näher gezeigter Weise gewellten Überlaufrand 12 versehen ist, ist eine zu reinigende Siliziumscheibe 14 in nicht dargestellter Weise gehalten. Im Boden 16 des Behälters 10 ist eine Öffnung 18 zum Einleiten von Reinigungs- oder Spülflüssigkeit vorgesehen. Über die Öffnung 18 ist ein Prallschild 20 und über diesem ein den ganzen Querschnitt des Behälters überdeckender Lochboden 22 zum Verteilen der durch die Öffnung 28 eintretenden Flüssigkeit angeordnet. Diese Flüssigkeit strömt daher im wesentlichen laminar nach oben um die zu reinigende Siliziumscheibe. In der Figur bezeichnet 24 eine Prozeßhorde, in der die Si-Scheiben (z. B. 25 an der Zahl) während der Behandlung gehalten werden; eine hordenfreie Halterung ("Carrierless") wird jedoch als vorteilhafter angesehen.

Durch eine Zuleitung 26 wird ultrareines Wasser zugeführt und entweder über ein Sperrventil 28 und eine Leitung 30 direkt der Öffnung 18 zugeführt oder über ein Sperrventil 32 und eine Leitung 34 sowie eine am Ende der Leitung 34 eingebaute Saugpumpe 36 ebenfalls der Öffnung 18 zugeführt. Über jeweils ein Sperrventil 38, 40 bzw. 42 sind weitere Leitungen 44, 46 und 48 an die Leitung 34 angeschlossen, wobei durch die Leitung 44 HF, durch die Leitung 46 $O_3$ oder vorzugsweise ein Gemisch von $O_2$ und $O_3$ sowie durch die Leitung 48 ein Tensid, vorzugsweise ein Fluortensid, zugeführt werden. Über eine Verbindungsleitung 50 mit einem eingebauten Sperrventil 52 sowie über eine weitere Verbindungsleitung 54 mit eingebautem Sperrventil 56 ist die Leitung 34 mit der Leitung 30 verbunden. In die Leitung 34 ist zwischen den Anschlüssen der Leitung 44 und 46 ein Sperrventil 58 und zwischen die Leitungen 46 und 48 ein Sperrventil 60 eingebaut.

Der Behälter 10 ist von einem etwas höheren und weiteren Auffangbehälter 62 umgeben, in welchen über den Überlaufrand 12 des Behälters 10 ausströmende Reinigungsflüssigkeit oder Spülflüssigkeit (ultrareines Wasser) einfließt. Vom Boden des Auffangbehälters 62 führt eine ein Sperrventil 64 enthaltende Leitung 66 zu einem nicht gezeigten Ablauf und eine ein Sperrventil 68 enthaltende Leitung 70 in einen Vorlagebehälter 72 für aus dem Auffangbehälter 62 stammendes Reinigungsmittel. Der Boden 16 des Behälters 10 ist über eine weitere, ein Sperrventil 74 enthaltende Leitung 76 ebenfalls mit dem nicht gezeigten Ablauf und über eine davon abzweigende, ein Sperrventil 78 enthaltende Leitung 80 mit dem Vorlagebehälter 72 verbunden.

Vom Vorlagebehälter 72 geht ferner eine Leitung 82 aus, in die ein elektrischer Durchlauferhitzer 84 eingebaut ist, wobei das Ausströmende des Durchlauferhitzers über eine weitere Leitung 86 wiederum mit dem Vorlagebehälter 72 verbunden ist. In nicht näher gezeigter Weise kann im Vorlagebehälter 72 befindliches Reinigungsmittel durch die Leitungen 82, 86 sowie den Durchlauferhitzer 84 geleitet werden, um eine Erwärmung des Reinigungsmittels zu erzielen.

Sämtliche dargestellten Sperrventile können vorzugsweise elektrisch gesteuert werden, wodurch es möglich ist, durch einer für den Fachmann aus dem dargestellten Schaltplan ohne weiteres ersichtlichen Weise Reinigungsflüssigkeit mit frei wählbaren Konzentrationsverhältnissen ihrer in ultrareines Wasser eingeleiteten Bestandteile oder aber ultrareines Wasser alleine in den Behälter 10 einzuleiten und die Flüssigkeiten entweder zum Ablauf oder im Fall von Reinigungsflüssigkeit in den Vorlagebehälter 72 zu leiten und wahlweise auch über eine weitere, den Vorlage-hälter 72 mit der Leitung 34 verbindende und ein Sperrventil 88 enthaltende Leitung 90 in den Behälter 10 zu rezirku-

**EP 0 731 495 B1**

lieren. Über die Leitung 80 kann auch der Inhalt des Vorlagebehälters 72 abgelassen werden. Die Strömungsgeschwindigkeit im Behälter 10, der vorzugsweise aus PVDF besteht, wird durch Änderung der Leistung der Pumpe 36 eingestellt. Die in die Flüssigkeit über die Leitung 46 eingeleitete Ozonmenge kann an einem nicht dargestellten, an die Leitung 46 angeschlossenen Ozongenerator durch die an diesen angelegte Spannung und durch einen definierten Sauerstoffstrom vorgegeben werden. Durch Mengenmessung des durch die Leitung 46 einströmenden $O_2/O_3$-Gemischs in einer dem Fachmann geläufigen Weise kann man die Konzentration des Ozons in diesem Gasstrom ermitteln, der in die Saugleitung 34 der Pumpe 36 eingeleitet wird.

Da Ozon ($O_3$) durch den Zerfall zu $O_2$ und O-Radikalen viele sekundäre Radikalreaktionen auslöst, ist eine exakte direkte Messung des Ozongehalts und somit der Oxidationskraft im Behälter 10 nicht möglich. Nachfolgend wird jedoch ein Versuchsbeispiel für die Wirkung des erfindungsgemäßen Verfahrens angegeben, wobei die Reinigungsflüssigkeit über den Vorlagebehälter 72 rezirkuliert wird. Durch die nachfolgend angegebenen Reinigungsergebnisse können Rückschlüsse auf die relative Ozonkonzentration im Behälter 10 gezogen werden.

Es wurde eine Versuchsreihe durchgeführt, in der die HF-Konzentration, die Behandlungszeit und die Menge an zugegebenem Tensid variiert wurden. Die Ergebnisse werden den Restmetallwerten nach einer konventionellen RCA-Reinigung gegenübergestellt. Werte für die Durchführung des Ohmi-Verfahrens lagen nicht vor.

Nachfolgend bezeichnen die Abkürzungen:

NWG = Nachweisgrenze,

E = Exponent zur Basis 10,

DI = deionisiert,

$C_{HF}$ = Konzentration von HF,

%ig = Gewichtsprozent bezogen auf g/l für Flüssigkeiten bzw. mg/l für Gase,

at = Atome.

1. Tabelle der Verfahrensparameter

| | | Versuchsnummer | | | |
|---|---|---|---|---|---|
| | | 1 | 2 | 3 | 4 |
| DI-Wasser | (l) | 49,569 | 45,690 | 45,690 | 45,690 |
| HF (50%ig) | (l) | 0,431 | 4,310 | 4,310 | 4,310 |
| $C_{HF}$ | (%ig) | 0,5 | 5,0 | 5,0 | 5,0 |
| Tensid (ml) | | 0,0 | 0,0 | 0,0 | 0,2 |
| $O_3$-Erzeugung | (g/h) | 30 | 30 | 30 | 30 |
| $O_2/O_3$-Strom | (l/h) | 250 | 250 | 250 | 250 |
| $O_3$-Konzentration | (mg/l) | 120 | 120 | 120 | 120 |
| Umwälzung | (l/min) | 65 | 65 | 65 | 65 |
| Temperatur | (°C) | 22 | 22 | 22 | 22 |
| Behandlungszeit | (min) | 3 | 3 | 6 | 3 |

2. **Ergebnisse:** ((at/cm$^2$) ; NWG : <1.0E+09)

| | Versuch-Nr. | | | | RCA-Reinigung | |
|---|---|---|---|---|---|---|
| | 1 | 2 | 3 | 4 | Ref1 | Ref2 |
| Fe | 2.7E+11 | 1.2E+10 | 1.1E+10 | 1.5E+09 | <1.0E+09 | <1.0E+09 |
| Cu | 3.1E+09 | <1.0E+09 | <1.0E+09 | <1.0E+09 | 6.5E+09 | 1.0E+10 |
| Ni | 5.7E+09 | 1.4E+09 | <1.0E+09 | <1.0E+09 | 5.6E+09 | 6.3E+09 |
| Zn | 3.9E+10 | 1.7E+10 | 4.4E+09 | 2.7E+09 | <1.0E+09 | 4.0E+09 |
| Cr | 4.1E+09 | <1.0E+09 | <1.0E+09 | <1.0E+09 | <1.0E+09 | <1.0E+09 |

Die Versuchsergebnisse zeigen, daß eine Änderung der Verfahrensparameter den Reinigungsvorgang beeinflußt. Eine Verlängerung der Behandlungszeit führt jeweils zu einer Metallreduzierung bis auf den Wert, der unter den jeweils gewählten Verfahrensparametern möglich ist. Eine Erhöhung der HF-Konzentration bei konstanter $O_3$-Erzeugung ermöglicht eine Verkürzung der Behandlungszeit und führt zu einer Herabsetzung der erreichbaren Metallwerte. Indirekt kann dabei eine Erhöhung der aktiven Ozonkonzentration im Behälter 10 mitwirken, da mit steigender HF-Konzentration bei gleicher Ozonerzeugung mehr Ozon in der Reinigungsflüssigkeit gelöst wird. Der Zusatz von geringsten Mengen an Tensiden führt zu einer optimalen Gasverteilung im Behälter und fördert somit die Löslichkeit und die Reaktivität des Ozons. Es ist auch wahrscheinlich, daß eine Steigerung der Ozonerzeugung bei sonst konstanten Verfahrensbedingungen die Reinigungswirkung beschleunigt und erhöht.

Folgende Bereiche der Verfahrensparameter sind für die Durchführung des erfindungsgemäßen Verfahrens optimal bzw. möglich:

**BEREICHE DER PROZESSPARAMETER:**

|  | optimaler Bereich | möglicher Bereich |
|---|---|---|
| HF-Konzentration | 0,01 - 10 %ig | 0,0 . 50,0 %ig |
| Tensid Menge | 0,0001 - 0,01 %ig | 0,000001 - 10,0 %ig |
| Ozonerzeugung | 10 - 100 g/h | 0,1 - 2000,0 g/h |
| $O_2/O_3$- Strom | 30 - 300 l/h | 1 - 1000 l/h |
| Temperatur | 20 50 °C | 1 - 99 °C |
| Umwälzung | 10 - 150 l/min | 0,1 - 1000 l/min |

Wie eingangs erwähnt, gehört zum Reinigungsprozeß vorteilhafterweise auch ein Säurefreispülen am Ende der Behandlungszeit und ein Hydrophylieren der Si-Oberflächen mit $O_3$ in deionisiertem Wasser bei einer HF-Konzentration von 0,0. Deshalb ist in der obigen Tabelle auch dieser Wert aufgenommen.

**Patentansprüche**

1.  Verfahren zum Reinigen von Siliziumscheiben, bei welchem die Siliziumscheiben in ein Bad gebracht werden, das als Reinigungsflüssigkeit aus einer mit einem $O_3$-Gasstrom (Ozon) durchströmten wässrigen HF-Lösung besteht, **dadurch gekennzeichnet,**

    a) dass die HF-Konzentration 0,01 bis 10 %ig ist,
    b) dass der Reinigungsflüssigkeit $10^{-6}$ bis 10 % eines Tensides zugegeben wird, und
    c) dass das Verhältnis der Konzentrationen von $O_3$ : HF während der Reinigung vergrößert wird.

2.  Verfahren nach Anspruch 1,
    **dadurch gekennzeichnet,** dass man der Reinigungsflüssigkeit $10^{-4}$ bis $10^{-2}$ % eines Tensides zugibt.

3.  Verfahren nach Anspruch 1 oder 2,
    **dadurch gekennzeichnet,** dass man der Reinigungsflüssigkeit eine Temperatur zwischen 1 und 99°C erteilt.

4.  Verfahren nach Anspruch 3,
    **dadurch gekennzeichnet,** dass man der Reinigungsflüssigkeit eine Temperatur zwischen 20 und 50 °C erteilt.

5.  Verfahren nach einem der vorangehenden Ansprüche,
    **dadurch gekennzeichnet**, dass man die Reinigungsflüssigkeit durch das Bad an den Siliziumscheiben vorbeiströmen lässt.

6.  Verfahren nach Anspruch 5,
    **dadurch gekennzeichnet,** dass man die Reinigungsflüssigkeit durch ein Bad mit einem Volumen von etwa 30 l mit einer Geschwindigkeit von 0,1 - 1000 l/min durchströmen lässt.

**7.** Verfahren nach Anspruch 6,
**dadurch gekennzeichnet,** dass man die Reinigungsflüssigkeit durch das Bad mit einer Geschwindigkeit von 10 bis 150 l/min durchströmen lässt.

**8.** Verfahren nach einem der vorangehenden Ansprüche,
**dadurch gekennzeichnet,** dass nacheinander mehrere von Spülvorgängen mit ultrareinem Wasser unterbrochene und abgeschlossene Reinigungen durchgeführt werden, wobei in der Reinigungsflüssigkeit jeder nachfolgenden Reinigung die Konzentration von $O_3$ : HF größer ist als bei der vorangehenden Reinigung.

**9.** Verfahren nach einem der vorangehenden Ansprüche,
**dadurch gekennzeichnet,** dass der gesamte Reinigungsvorgang in einem einzigen Behälter durchgeführt wird.

**10.** Verfahren nach einem der Ansprüche 6 bis 9,
**dadurch gekennzeichnet,** dass man die Reinigungsflüssigkeit laminar an den Siliziumscheiben vorbeiströmen lässt.

**11.** Verfahren nach einem der Ansprüche 6 bis 10,
**dadurch gekennzeichnet,** dass man die Reinigungsflüssigkeit nach dem Durchströmen des Bades rezirkuliert.

**12.** Vorrichtung zur Durchführung des Verfahrens nach einem der vorangehenden Ansprüche,
**gekennzeichnet** durch einen Behälter zur Aufnahme von Siliziumscheiben in einem Bad von Reinigungsflüssigkeit, wobei eine Einrichtung vorgesehen ist zur Bereitstellung der aus einer mit einem $O_3$-Gasstrom durchströmten wässrigen HF-Lösung mit einer HF-Konzentration 0,01 bis 10 %ig und einem zugegebenen Tensid von 10-6 bis 10 %, sowie mit einer Einrichtung, durch welche das Verhältnis der Konzentration von $O_3$ : HF während der Reinigung vergrößerbar ist, und durch mindestens eine Öffnung (18) im Boden (16) des Behälter (10) zur Einleitung der Reinigungsflüssigkeit, und durch einem im Abstand oberhalb der Öffnung (18) den Querschnitt des Behälters (10) überdeckenden Lochboden (22) zur Verteilung der Reinigungsflüssigkeit, und durch Einrichtungen zur Zuführung der Reinigungsflüssigkeit zu der Öffnung (18).

**13.** Vorrichtung nach Anspruch 12,
**dadurch gekennzeichnet,** dass innerhalb der Öffnung (18) des Behälters (10) ein Prallschild (20) zur Verteilung der durch die Öffnung (18) eingeleiteten Flüssigkeit angeordnet ist.

**14.** Vorrichtung nach Anspruch 12 oder 13,
**dadurch gekennzeichnet,** dass für die den oberen Rand (12) des Behälters (10) verlassende Flüssigkeit eine Überlaufsammeleinrichtung (62) vorgesehen ist, die über eine Rückleitung (70) mit einem Vorlagebehälter (72) verbunden ist.

**15.** Vorrichtung nach Anspruch 14,
**dadurch gekennzeichnet,** dass am Vorlagebehälter (72) eine Heizeinrichtung (84) für die Reinigungsflüssigkeit vorgesehen ist.

**16.** Vorrichtung nach Anspruch 15,
**dadurch gekennzeichnet,** dass die zirkulierte Behandlungsflüssigkeit über einen Filter geleitet wird, um von der Si-Oberfläche bereits abgelöste Partikel aus dem System auszuschleusen.

**17.** Vorrichtung nach Anspruch 16,
**dadurch gekennzeichnet,** dass der obere Rand (12) des Behälters (10) gewellt ausgeführt ist, so dass die Flüssigkeit rundum gleichmäßig überläuft.

## Claims

**1.** Process for cleaning silicon wafers, in which the silicon wafers are placed in a bath which is formed as a cleaning fluid from an aqueous HF solution through which an $O_3$ (ozone) gas flow is passed, characterized in that

a) the HF concentration is from 0.01 to 10%
b) $10^{-6}$ to 10% of a surfactant is added to the cleaning fluid, and

c) the $O_3$: HF concentration ratio is increased during cleaning.

2. Process according to Claim 1, characterized in that $10^{-4}$ to $10^{-2}$% of a surfactant is added to the cleaning fluid.

3. Process according to Claim 1 or 2, characterized in that the cleaning fluid is given a temperature between 1 and 99°C.

4. Process according to Claim 3, characterized in that the cleaning fluid is given a temperature between 20 and 50°C.

5. Process according to one of the preceding claims, characterized in that the cleaning fluid is fed past the silicon wafers through the bath.

6. Process according to Claim 5, characterized in that the cleaning fluid is fed past through a bath with a volume of about 30 l at a rate of from 0.1 - 1000 l/min.

7. Process according to Claim 6, characterized in that the cleaning fluid is fed through the bath at a rate of from 10 to 150 l/min.

8. Process according to one of the preceding claims, characterized in that a plurality of cleaning operations, interrupted and concluded by washing processes using ultrapure water, are carried out successively, the $O_3$:HF concentration in the cleaning fluid of each successive cleaning operation being greater than that of the previous cleaning operation.

9. Process according to one of the preceding claims, characterized in that all of the cleaning process is carried out in the same container.

10. Process according to one of Claims 6 to 9, characterized in that the cleaning fluid is fed past the silicon wafers in laminar flow.

11. Process according to one of Claims 6 to 10, characterized in that the cleaning fluid is recirculated after it has flowed through the bath.

12. Device for carrying out the process according to one of the preceding claims, characterized by a container for holding silicon wafers in a bath of cleaning fluid, an instrument being provided for supplying the [lacuna] of an aqueous HF solution through which a $O_3$ gas flow is passed with an HF concentration from 0.01 to 10% and $10^{-6}$ to 10% added surfactant, and with a device by which the $O_3$:HF ratio of the concentration can be increased during the cleaning, and by at least one opening (18) in the bottom (16) of the container (10) for admitting the cleaning fluid, and by a perforated bottom (22), covering the cross section of the container (10) at a distance above the opening (18), for distributing the cleaning fluid, and by instruments for delivering the cleaning fluid to the opening (18).

13. Device according to Claim 12, characterized in that an impact shield (20) for distributing the fluid admitted through the opening (18) is provided inside the opening (18) of the container (10).

14. Device according to Claim 12 or 13, characterized in that an overflow collection instrument (62), which is connected to a storage container (72) via a return line (70), is provided for the fluid leaving the upper edge (12) of the container (10).

15. Device according to Claim 14, characterized in that the storage container (72) is provided with a heating instrument (84) for the cleaning fluid.

16. Device according to Claim 15, characterized in that the circulated treatment fluid is fed through a filter in order to remove the particles already detached from the Si surface from the system.

17. Device according to Claim 16, characterized in that the upper edge (12) of the container (10) is of corrugated design so that the fluid overflows uniformly all around.

**Revendications**

1.  Procédé d'épuration de tranches de silicium, pour lequel les tranches de silicium sont placées dans un bain, constitué d'un liquide de nettoyage composé d'une solution aqueuse HF traversée par un écoulement d'un flux gazeux d'$O_3$ (ozone),
    caractérisé en ce que,

    a) la concentration en HF est de 0,01 à 10 %,
    b) au liquide de nettoyage est ajouté de $10^{-6}$ à 10 % d'un tensioactif, et
    c) le rapport entre des concentrations $O_3$ : HF est augmenté pendant le nettoyage.

2.  Procédé selon la revendication 1,
    caractérisé en ce qu'
    on ajoute au liquide de nettoyage de $10^{-4}$ à $10^{-2}$ % d'un tensioactif.

3.  Procédé selon la revendication 1 ou 2,
    caractérisé en ce qu'
    on donne au liquide de nettoyage une température comprise entre 1 et 99°C.

4.  Procédé selon la revendication 3,
    caractérisé en ce qu'
    on donne au liquide de nettoyage une température comprise entre 20 et 50°C.

5.  Procédé selon l'une des revendications précédentes,
    caractérisé en ce qu'
    on fait s'écouler le liquide de nettoyage se trouvant dans le bain sur les tranches de silicium.

6.  Procédé selon la revendication 5,
    caractérisé en ce que
    le liquide de nettoyage dans un bain d'un volume d'environ 30 litres a un débit de 0,1 - 1000 l/min.

7.  Procédé selon la revendication 6,
    caractérisé en ce que
    le liquide de nettoyage se trouvant dans le bain a un débit de 10 à 150 l/min.

8.  Procédé selon l'une des revendications précédentes,
    caractérisé en ce qu'
    on effectue les uns après les autres plusieurs nettoyages, interrompus par des processus de rinçage avec de l'eau ultra-pure et achevés, le rapport en des concentrations $O_3$:HF dans le liquide de nettoyage de chaque nettoyage subséquent étant supérieur à ce qu'elle est lors du nettoyage précédent.

9.  Procédé selon l'une des revendications précédentes,
    caractérisé en ce que
    l'ensemble du processus de nettoyage est effectué dans un réservoir unique.

10. Procédé selon l'une des revendications 6 à 9
    caractérisé en ce qu'
    on fait passer le liquide de nettoyage en écoulement laminaire sur les tranches de silicium.

11. Procédé selon l'une des revendications 6 à 10,
    caractérisé en ce qu'
    on fait recirculer le liquide de nettoyage après qu'il soit passé dans le bain.

12. Dispositif de mise en oeuvre du procédé selon une des revendications précédentes,
    caractérisé par
    un réservoir destiné à contenir les tranches de silicium dans un bain de liquide de nettoyage, un dispositif étant prévu pour préparer la solution aqueuse HF qui est traversée par un écoulement d'un flux gazeux de $O_3$, avec une concentration en HF de 0,001 à 10 %, et addition d'un tensioactif à concurrence de $10^{-6}$ à 10 %, ainsi que par un dispositif au moyen duquel le rapport entre les concentrations $O_3$:HF pendant le nettoyage peut être augmenté, par au moins une ouverture (18) ménagée dans le fond (16) du réservoir (10) pour introduire le liquide de nettoyage, et par un fond perforé (22) placé à distance au-dessus de l'ouverture (18) et recouvrant la section transversale du réservoir (10), pour distribuer le liquide de nettoyage, ainsi que par des dispositifs pour amener le liquide de nettoyage à l'ouverture (18).

13. Dispositif selon la revendication 12,
    caractérisé en ce qu'
    à l'intérieur de l'ouverture (18) du réservoir (10) est disposé un bouclier d'impact (20) destiné à distribuer le liquide introduit par l'ouverture (18).

14. Dispositif selon la revendication 12 ou 13,
    caractérisé en ce qu'
    un dispositif collecteur de déversement (62) relié à un réservoir d'alimentation (72) par une conduite de retour (70) est prévu pour le liquide quittant le bord supérieur (12) du réservoir (10).

15. Dispositif selon la revendication 14,
    caractérisé en ce qu'
    un dispositif de chauffage (84) destiné au liquide de nettoyage est prévu sur le réservoir d'alimentation (72).

16. Dispositif selon la revendication 15,
    caractérisé en ce que
    le liquide de traitement mis en circulation passe par un filtre pour éliminer du système les particules s'étant déjà désolidarisées de la surface de Si.

17. Dispositif selon la revendication 16,
    caractérisé en ce que
    le bord supérieur (12) du récipient (10) est ondulé, si bien que le liquide se déverse régulièrement sur tout le pourtour.